# EUROPEAN PATENT APPLICATION

(11) **EP 4 600 678 A1**
(43) Date of publication of application: **13.08.2025**
(21) Application number: 23889216.0
(22) Date of filing: 10.11.2023
(51) Int. Cl.: G01R 31/392, G01R 31/56, G01R 31/3835, G01R 19/00, G01R 19/10, G01R 31/367, G01R 31/396, G01R 31/3842, G01R 19/12

(54) **BATTERY MANAGEMENT DEVICE AND OPERATION METHOD THEREFOR**

(30) Priority: 11.11.2022 KR 20220151066; 11.11.2022 KR 20220151067
(71) Applicant: LG Energy Solution, Ltd., Seoul 07335 (KR)
(72) Inventor: LEE, Sun Jong, Daejeon 34122 (KR); KIM, Na Ri, Daejeon 34122 (KR); KIM, Cheol Taek, Daejeon 34122 (KR)
(74) Representative: Plasseraud IP
(86) International application number: PCT/KR2023/018100
(87) International publication number: WO 2024/101960

(57) **Abstract**

A battery management apparatus according to an embodiment disclosed herein includes an information obtaining unit configured to obtain an open circuit voltage of a plurality of battery cells and a controller configured to calculate a first voltage of each of the plurality of battery cells, which is related to a change in open circuit voltage of the plurality of battery cells, for a preset time, calculate a second voltage that is an average of the first voltage of each of the plurality of battery cells, calculate a deviation based on a first voltage and a second voltage of each of the plurality of battery cells, and diagnose the plurality of battery cells based on a ratio of the first voltage and the second voltage of each of the plurality of battery cells and the deviation.

## Description

### [TECHNICAL FIELD]

### CROSS-REFERENCE TO RELATED APPLICATION

This application claims priority to and the benefit of Korean Patent Application No. 10-2022-0151067 filed in the Korean Intellectual Property Office on November 11, 2022 and Korean Patent Application No. 10-2022-0151066 filed in the Korean Intellectual Property Office on November 11, 2022, the entire contents of which are incorporated herein by reference.

### TECHNICAL FIELD

Embodiments disclosed herein relate to a battery management apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Batteries used in vehicles or energy storage systems (ESS) may have a significant risk when a fire occurs during use. A severe internal short-circuit of the battery may lead to thermal runaway and cause a fire, and one of causes for the internal short-circuit is lithium precipitation on a negative electrode surface of the battery. Lithium ions from a positive electrode are reduced into a negative electrode during charging for a normal battery, whereas for a defective battery, some lithium ions may be precipitated in the form of lithium metal on the negative electrode surface and the precipitated lithium may continuously grow and contact a positive electrode or a positive electrode collector, resulting in an internal short-circuit.

### [DISCLOSURE]

### [TECHNICAL PROBLEM]

Embodiments disclosed herein aim to provide a battery management apparatus and an operating method thereof in which tab disconnection of a plurality of battery cells may be diagnosed.

Embodiments disclosed herein aim to provide a battery management apparatus and an operating method thereof in which states of a plurality of battery cells may be diagnosed based on an idle period voltage after charging/discharging of the plurality of battery cells.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment disclosed herein includes an information obtaining unit configured to obtain an open circuit voltage of a plurality of battery cells and a controller configured to calculate a first voltage of each of the plurality of battery cells, which is related to a change in open circuit voltage of the plurality of battery cells, for a preset time, calculate a second voltage that is an average of the first voltage of each of the plurality of battery cells, calculate a deviation based on a first voltage and a second voltage of each of the plurality of battery cells, and diagnose the plurality of battery cells based on a ratio of the first voltage and the second voltage of each of the plurality of battery cells and the deviation.

According to an embodiment, the controller may be further configured to diagnose the plurality of battery cells a plurality of times and finally diagnose, as a defective battery cell, a battery cell diagnosed a number of times greater than or equal to a preset number of times.

According to an embodiment, the controller may be further configured to diagnose the plurality of battery cells every discharging after the plurality of battery cells are discharged a plurality of times.

According to an embodiment, the controller may be further configured to diagnose, among the plurality of battery cells, as a defective battery cell, a battery cell having a ratio of a first voltage and a second voltage, the ratio being out of a preset range.

According to an embodiment, the first voltage may be an open circuit voltage recovered after a battery cell is used.

According to an embodiment, the information obtaining unit may be further configured to obtain an open circuit voltage of the plurality of battery cells after a preset time from charging or discharging of the plurality of battery cells.

According to an embodiment, the controller may be further configured to diagnose, among the plurality of battery cells, as a defective battery cell, a battery cell having a ratio and a deviation of a first voltage and a second voltage, the ratio being out of a preset range and the deviation being greater than or equal to a set value.

According to an embodiment, the controller may be further configured to finally diagnose a battery cell as a defective battery cell when the battery cell is diagnosed, as having the ratio being out of the preset range and the deviation of the second voltage being greater than or equal to the preset value, continuously a preset number of times.

According to an embodiment, the controller may be further configured to determine a battery cell as noise without performing diagnosis, when the battery cell has a change in open circuit voltage of the plurality of battery cells, the change being greater than or equal to a threshold value.

According to an embodiment, the controller may be further configured to define a ranking of each of the plurality of battery cells based on a ratio of the first voltage and the second voltage of each of the plurality of battery cells and diagnose the plurality of battery cells based on the ranking of each of the plurality of battery cells.

According to an embodiment, the controller may be further configured to determine, among the plurality of battery cells, a first battery cell having the greatest ratio of the first voltage and the second voltage, a second battery cell having the second greatest ratio, and a third battery cell having the least ratio, calculate a first difference that is a difference between the ratio of the first battery cell and the ratio of the second battery cell, calculate a second difference that is a difference between the ratio of the second battery cell and the ratio of the third battery cell, and diagnose a state of the first battery cell based on the ratio of the first battery cell, the first difference, and the third difference.

According to an embodiment, the controller may be further configured to diagnose, as a defective battery cell, a battery cell having a ratio of the first battery cell being greater than or equal to a first threshold value, a ratio of the first difference and the second difference being greater than or equal to a second threshold value, and the deviation being greater than or equal to a preset value.

An operating method of a battery management apparatus according to an embodiment disclosed herein includes obtaining an open circuit voltage of a plurality of battery cells, calculating a first voltage of each of the plurality of battery cells, which is related to a change in open circuit voltage of the plurality of battery cells, for a preset time, calculating a second voltage that is an average of the first voltage of each of the plurality of battery cells, calculating a deviation based on a first voltage and a second voltage of each of the plurality of battery cells, and diagnosing the plurality of battery cells based on a ratio of the first voltage and the second voltage of each of the plurality of battery cells and the deviation.

According to an embodiment, the defining of the plurality of battery cells based on the ratio of the first voltage and the second voltage of each of the plurality of battery cells may include diagnosing the plurality of battery cells a plurality of times and finally diagnosing, as a defective battery cell, a battery cell diagnosed a number of times greater than or equal to a preset number of times.

According to an embodiment, the diagnosing of the plurality of battery cells a plurality of times may include diagnosing the plurality of battery cells every discharging after the plurality of battery cells are discharged a plurality of times.

According to an embodiment, the defining of the plurality of battery cells based on the ratio of the first voltage and the second voltage of each of the plurality of battery cells may include diagnosing, among the plurality of battery cells, as a defective battery cell, a battery cell having a ratio of a first voltage and a second voltage, the ratio being out of a preset range.

According to an embodiment, the obtaining of the open circuit voltage of a plurality of battery cells may include obtaining an open circuit voltage of the plurality of battery cells after a preset time from charging or discharging of the plurality of battery cells.

According to an embodiment, the operating method may further include defining a ranking of each of the plurality of battery cells based on a ratio of the first voltage and the second voltage of each of the plurality of battery cells and diagnosing the plurality of battery cells based on the ranking of each of the plurality of battery cells.

According to an embodiment, the diagnosing of the plurality of battery cells based on the ranking of each of the plurality of battery cells may include determining, among the plurality of battery cells, a first battery cell having the greatest ratio of the first voltage and the second voltage, a second battery cell having the second greatest ratio, and a third battery cell having the least ratio, calculating a first difference that is a difference between the ratio of the first battery cell and the ratio of the second battery cell, calculating a second difference that is a difference between the ratio of the second battery cell and the ratio of the third battery cell, and diagnosing a state of the first battery cell based on the ratio of the first battery cell, the first difference, and the third difference.

### [ADVANTAGEOUS EFFECTS]

The battery measurement apparatus and the operating method thereof according to an embodiment disclosed herein may accurately diagnose tab disconnection of a plurality of battery cells.

The battery management apparatus and the operating method thereof according to an embodiment disclosed herein may diagnose states of a plurality of battery cells by calculating a voltage change for each battery cell based on an idle period voltage after charging/discharging of the plurality of battery cells.

The battery management apparatus and the operating method thereof according to an embodiment disclosed herein may diagnose tab disconnection of at least any one of a plurality of battery cells based on a ratio of an open circuit voltage change of a plurality of battery cells to an average of open circuit voltage changes.

The battery management apparatus and the operating method thereof according to an embodiment disclosed herein may diagnose tab disconnection of at least any one of a plurality of battery cells based on a ranking of a ratio of a voltage change of a plurality of battery cells to an average voltage change.

Moreover, various effects recognized directly or indirectly from the disclosure may be provided.

### [DESCRIPTION OF DRAWINGS]

FIG. 1 is a block diagram showing a configuration of a general battery pack.
FIG. 2 is a block diagram of a battery management apparatus according to an embodiment disclosed herein.
FIG. 3 is a view for describing an example in which a battery management apparatus according to an embodiment disclosed herein diagnoses a plurality of battery cells.
FIGS. 4A, 4B, and 4C are views for describing an example in which a battery management apparatus according to an embodiment disclosed herein diagnoses a plurality of battery cells.
FIG. 5 is a flowchart of an operating method of a battery management apparatus according to an embodiment disclosed herein.
FIG. 6 is a flowchart showing an operating method of a battery management apparatus, according to an embodiment disclosed herein.
FIG. 7 is a flowchart showing an operating method of a battery management apparatus, according to another embodiment disclosed herein.
FIG. 8 is a flowchart showing in detail an operating method of a battery management apparatus, according to another embodiment disclosed herein.
FIG. 9 is a block diagram showing a hardware configuration of a computing system for performing an operating method of a battery management apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

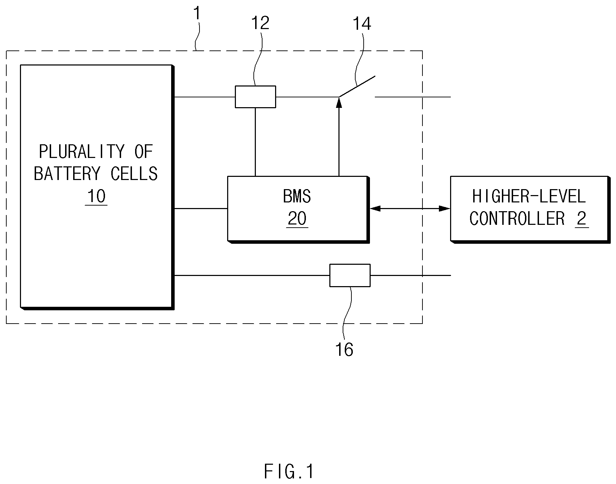

FIG. 1 is a block diagram showing a configuration of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a plurality of battery cells 10 that include one or more battery cells and are chargeable/dischargeable, a switching unit 14 serially connected to positive (+) terminal sides or negative (-) terminal sides of the plurality of battery cells 10 to control a charging/discharging current flow of the plurality of battery cells 10, and a battery management system 20 for control and management to prevent over-charging and over-discharging by monitoring voltage, current, temperature, etc., of the battery pack 1. The battery pack 1 may include the plurality of battery cells 10, the sensor 12, the switching unit 14, and the battery management system 20 provided in plural.

Herein, as the switching unit 14 which is an element for controlling a current flow for charging or discharging of the plurality of battery cells 10, for example, at least one relay, magnetic contactor, etc., may be used according to specifications of the battery pack 1.

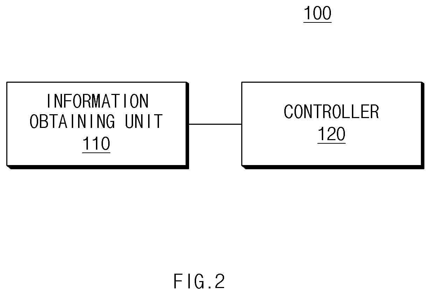

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the plurality of battery cells 10 to monitor the state of each battery cell 10. According to an embodiment, the battery management system 20 may include a battery management apparatus 100 of FIG. 2. According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1.

The higher-level controller 2 may transmit a control signal regarding the plurality of battery cells 10 to the battery management system 20. Thus, the battery management system 20 may also be controlled in terms of an operation thereof based on a signal applied from the higher-level controller 2.

FIG. 2 is a block diagram of a battery management apparatus according to an embodiment disclosed herein.

Referring to FIG. 2, the battery management apparatus 100 according to an embodiment disclosed herein may include an information obtaining unit 110 and a controller 120.

According to an embodiment, the battery management apparatus 100 may be included in the battery management system 20 of FIG. 1. According to another embodiment, the battery management apparatus 100 may be included in the higher-level controller 2 of FIG. 1. According to another embodiment, the battery management apparatus 100 may be included in a separate device not shown in the battery pack 1 of FIG. 1.

The information obtaining unit 110 may obtain open circuit voltages of the plurality of battery cells. For example, the information obtaining unit 110 may obtain an open circuit voltage of each of the plurality of battery cells.

According to an embodiment, the information obtaining unit 110 may obtain voltages of the plurality of battery cells in an idle period after an elapse of a preset time from charging or discharging of the plurality of battery cells. In the idle period, a battery cell having a disconnected tab may experience a rapid and large voltage change when compared to a normal battery cell, such that the information obtaining unit 110 may obtain the voltages of the plurality of battery cells in the idle period.

According to an embodiment, the information obtaining unit 110 may obtain the open circuit voltages of the plurality of battery cells after an elapse of a preset time from charging or discharging of the plurality of battery cells.

The controller 120 may calculate a first voltage of each of the plurality of battery cells, which is a change in open circuit voltage of each of the plurality of battery cells corresponding to two different times. For example, the controller 120 may calculate the first voltage of each of the plurality of battery cells by calculating a difference between an open circuit voltage of the plurality of battery cells corresponding to a first time and an open circuit voltage of the plurality of battery cells corresponding to a second time.

The controller 120 may calculate a second voltage that is an average of the first voltage of each of the plurality of battery cells. For example, the second voltage may be an average of open circuit voltage deviations of the plurality of battery cells corresponding to two different times.

The controller 120 may calculate a deviation based on the first voltage and the second voltage of each of the plurality of battery cells. For example, the controller 120 may calculate a standard deviation of the first voltage of each of the plurality of battery cells with respect to the second voltage.

The controller 120 may calculate a ratio of the first voltage and the second voltage of each of the plurality of battery cells. For example, the controller 120 may calculate the ratio for each of the plurality of battery cells by dividing the first voltage of each of the plurality of battery cells by the second voltage.

The controller 120 may diagnose the plurality of battery cells based on a ratio and a deviation of the first voltage and the second voltage of each of the plurality of battery cells. For example, the controller 120 may diagnose, among the plurality of battery cells, as a defective battery cell, a battery cell having a ratio of the first voltage and the second voltage being out of a preset range. Aaccording to an embodiment, the controller 120 may diagnose, among the plurality of battery cells, as a defective battery cell, a battery cell having the first voltage being out of a range from 0.8 times of the second voltage to 1.2 times of the second voltage.

According to an embodiment, the controller 120 may diagnose the plurality of battery cells a plurality of times. For example, the controller 120 may diagnose the plurality of battery cells for every discharging after the plurality of battery cells are discharged a plurality of times. In this case, the controller 120 may store a diagnosis result with respect to the plurality of battery cells every multiple times of diagnosis. The controller 120 may finally diagnose, as a defective battery cell, a battery cell having a number of times of diagnosis being greater than or equal to a preset number of times. For example, when the plurality of battery cells are discharged 10 times, the controller 120 may diagnose the plurality of battery cells after discharging and finally diagnose a battery cell diagnosed as defective 7 times or greater as a defective battery cell. Thus, the battery management apparatus 100 disclosed herein may minimize a possibility of occurrence of misdiagnosis. However, the present disclosure is not limited to the above-described values, and a user may adjust a preset number of times the battery cell is finally diagnosed through the controller 120.

According to an embodiment, the controller 120 may set two different times to be different from each other by a preset time. For example, the controller 120 may set two different times to be different from each other by 600 seconds.

According to an embodiment, the first voltage may be an open circuit voltage recovered after use of the battery cell.

According to an embodiment, the controller 120 may diagnose, as the defective battery cell, a battery cell having a ratio of a first voltage and a second voltage being out of a preset range and a deviation of the first voltage and the second voltage being greater than or equal to a preset value among the plurality of battery cells. For example, the controller 120 may finally diagnose the battery cell as the defective battery cell when the battery cell is diagnosed, as having the ratio being out of the preset range and the deviation of the second voltage being greater than or equal to the preset value, continuously a preset number of times. For example, the preset number of times may include two times, but may also be a greater number of times to reduce an error.

According to an embodiment, when the battery cell has a change in open circuit voltage of the plurality of battery cells being greater than or equal to a threshold value, the controller 120 may determine it as noise without performing diagnosis. For example, when the voltage change is greater than another battery cell or a preset threshold value, a possibility of noise is high, such that the controller 120 may perform diagnosis except for a value determined as noise.

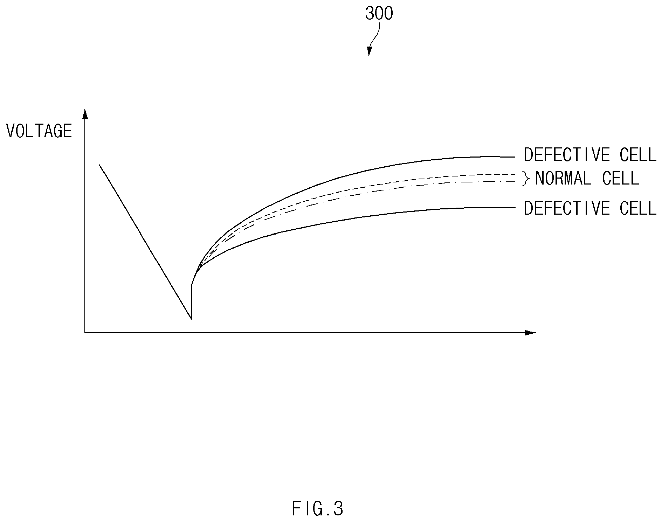

FIG. 3 is a view for describing an example in which a battery management apparatus according to an embodiment disclosed herein diagnoses a plurality of battery cells.

Referring to FIG. 3, the information obtaining unit 110 may time-serially obtain open circuit voltages 300 of the plurality of battery cells.

The controller 120 may calculate a change in open circuit voltage of each of the plurality of battery cells corresponding to two different times. For example, the controller 120 may a change in open circuit voltage of each of the plurality of battery cells based on a difference between a voltage of the plurality of battery cells corresponding to 600 seconds and a voltage of the plurality of battery cells corresponding to 1200 seconds.

The controller 120 may calculate a second voltage, which is an average of the first voltage of each of the plurality of battery cells, and diagnose a state of the plurality of battery cells, based on a ratio of the first voltage and the second voltage of each of the plurality of battery cells. For example, the controller 120 may diagnose, as a defective battery cell, a battery cell having a ratio of the first voltage and the second voltage of each of the plurality of battery cells, in which the ratio is out of a preset range. That is, the controller 120 may diagnose, as a defective battery cell, a battery cell in which a recovery ratio of an open circuit voltage is greater or less than a recovery ratio of an average open circuit voltage.

The battery measurement apparatus 100 according to an embodiment disclosed herein may accurately diagnose tab disconnection of a plurality of battery cells.

The battery management apparatus 100 according to an embodiment disclosed herein may diagnose states of a plurality of battery cells by calculating a voltage change for each battery cell based on an idle period voltage after charging/discharging of the plurality of battery cells.

The battery management apparatus 100 according to an embodiment disclosed herein may diagnose tab disconnection of at least any one of a plurality of battery cells based on a ratio of a voltage change of a plurality of battery cells to an average voltage change.

Referring back to FIG. 2, according to an embodiment, the information obtaining unit 110 may obtain voltages of the plurality of battery cells in an idle period after an elapse of a preset time from charging or discharging of the plurality of battery cells. In the idle period, a battery cell having a disconnected tab may experience a rapid and large voltage change when compared to a normal battery cell, such that the information obtaining unit 110 may obtain the voltages of the plurality of battery cells in the idle period.

The controller 120 may calculate a first voltage of each of the plurality of battery cells, which is related to a voltage change of each of the plurality of battery cells corresponding to two different times. For example, the controller 120 may calculate the first voltage of each of the plurality of battery cells by calculating a difference between a voltage of the plurality of battery cells corresponding to a first time and a voltage of the plurality of battery cells corresponding to a second time.

The controller 120 may calculate a second voltage that is an average of the first voltage of each of the plurality of battery cells. For example, the second voltage may be an average of voltage deviations of the plurality of battery cells corresponding to two different times.

The controller 120 may calculate a ratio of the first voltage and the second voltage of each of the plurality of battery cells. For example, the controller 120 may calculate the ratio for each of the plurality of battery cells by dividing the first voltage of each of the plurality of battery cells by the second voltage.

The controller 120 may define a ranking of each of the plurality of battery cells based on the ratio of the first voltage and the second voltage of each of the plurality of battery cells. For example, the controller 120 may define a ranking of each of the plurality of battery cells from the first ranking to the last ranking based on the ratio of each of the plurality of battery cells. In another example, the controller 120 may determine, among the plurality of battery cells, a first battery cell having the greatest ratio of the first voltage and the second voltage, a second battery cell having the second greatest ratio, and a third battery cell having the least ratio.

The controller 120 may diagnose the state of the plurality of battery cells, based on the ranking of each of the plurality of battery cells. For example, the controller 120 may calculate a first difference that is a difference between a ratio of a first battery cell (a ratio of a first voltage and a second voltage of the first battery cell) and a ratio of a second battery cell (a ratio of a first voltage and a second voltage of the second battery cell). The controller 120 may calculate a second difference that is a difference between the ratio of the second battery cell and a ratio of a third battery cell (a ratio of a first voltage and a second voltage of the third battery cell). In this case, the controller 120 may diagnose the state of the first battery cell based on the ratio of the first battery cell, the first difference, and the second difference.

According to an embodiment, the controller 120 may diagnose that tab disconnection occurs in the first battery cell, when the ratio of the first battery cell is greater than or equal to a first threshold value and a ratio of the first difference and the second difference is greater than or equal to a second threshold value.

According to an embodiment, the controller 120 may set two different times to be different from each other by a preset time. For example, the controller 120 may set two different times to be different from each other by 600 seconds. In another example, the controller 120 may periodically set two different times to be different from each other by a preset time such as 600 seconds, 1200 seconds, 1800 seconds, etc.

According to an embodiment, the controller 120 may diagnose the plurality of battery cells based on a ratio, a ranking, and a deviation of the first voltage and the second voltage of each of the plurality of battery cells. For example, the controller 120 may diagnose that the battery cell is not abnormal, when any one of the ratio, the ranking, and the deviation fails to satisfy a criterion. In another example, the controller 120 may diagnose that the battery cell is abnormal, when any one of the ratio, the ranking, and the deviation exceeds the criterion. That is, the controller 120 may diagnose the plurality of battery cells by collectively considering the ratio, the ranking, and the deviation.

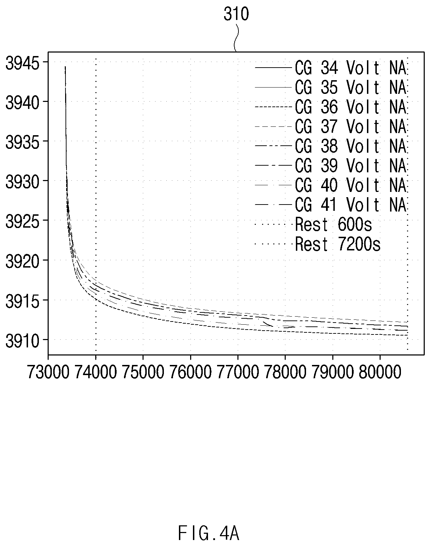

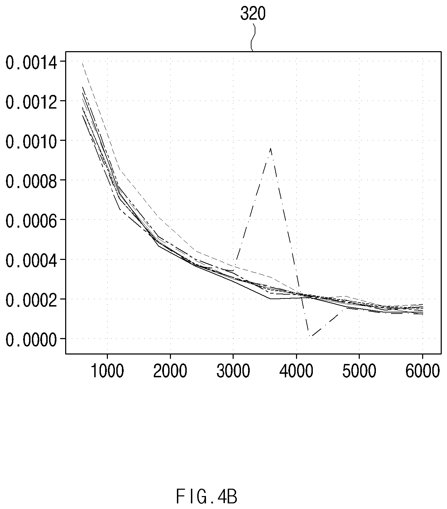

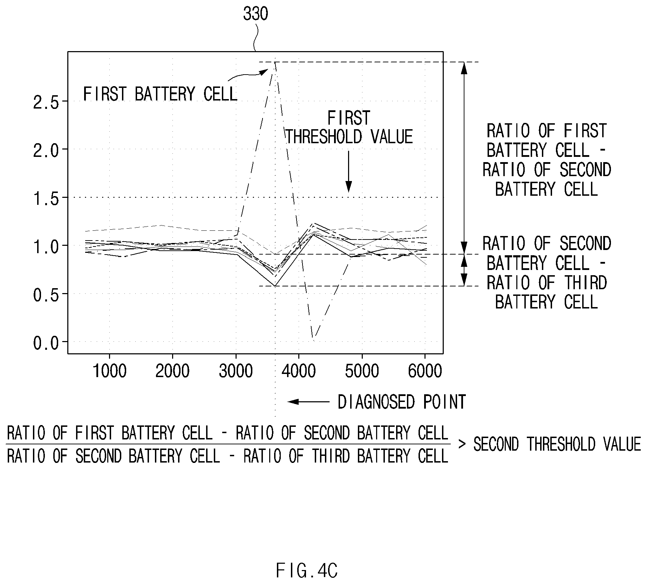

FIGS. 4A, 4B, and 4C are views for describing an example in which a battery management apparatus according to an embodiment disclosed herein diagnoses a plurality of battery cells.

Referring to FIGS. 4A, 4B, and 4C, the information obtaining unit 110 may time-serially obtain voltages 310 of the plurality of battery cells.

The controller 120 may calculate a voltage change of each of the plurality of battery cells corresponding to two different times. For example, the controller 120 may a voltage change of each of the plurality of battery cells based on a difference between a voltage of the plurality of battery cells corresponding to 600 seconds and a voltage of the plurality of battery cells corresponding to 1200 seconds. The controller 120 may a voltage change of each of the plurality of battery cells based on a difference between a voltage of the plurality of battery cells corresponding to 1200 seconds and a voltage of the plurality of battery cells corresponding to 1800 seconds. That is, the controller 120 may calculate a voltage change 320 of each of the plurality of battery cells every 600 seconds.

The controller 120 may calculate a second voltage, which is an average of the first voltage of each of the plurality of battery cells, and diagnose a ranking of each of the plurality of battery cells, based on a ratio 330 of the first voltage and the second voltage of each of the plurality of battery cells. For example, the controller 120 may determine the first battery cell having the greatest ratio of the first voltage and the second voltage, the second battery cell having the second greatest ratio, and the third battery cell having the least ratio, based on the ratio of the first voltage and the second voltage of each of the plurality of battery cells corresponding to 3600 seconds. In this case, the controller 120 may calculate the first difference that is the difference between the ratio of the first voltage and the second voltage of the first battery cell and the ratio of the first voltage and the second voltage of the second battery cell, and calculate the second difference that is the difference between the ratio of the first voltage and the second voltage of the second battery cell and the ratio of the first voltage and the second voltage of the third battery cell. The controller 120 may diagnose the state of the first battery cell based on the ratio of the first voltage and the second voltage of the first battery cell, the first difference, and the second difference.

According to an embodiment, the controller 120 may diagnose that tab disconnection occurs in the first battery cell, when the ratio of the first voltage and the second voltage of the first battery cell is greater than or equal to a first threshold value and a ratio of the first difference and the second difference is greater than or equal to a second threshold value. That is, the controller 120 may diagnose that tab disconnection occurs in the first battery cell at 3600 seconds.

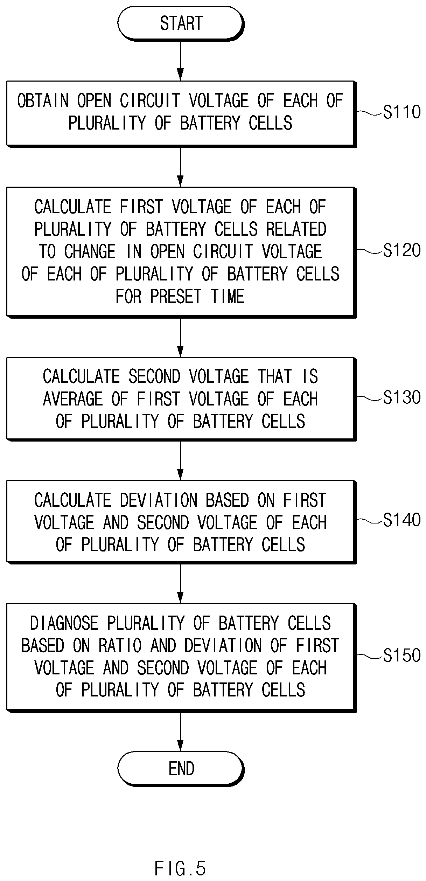

FIG. 5 is a flowchart of an operating method of a battery management apparatus according to an embodiment disclosed herein.

According to an embodiment, operations shown in FIG. 5 may be performed by the battery management apparatus 100 of FIG. 2.

In operation S 110, the information obtaining unit 110 may obtain an open circuit voltage of each of the plurality of battery cells. For example, the information obtaining unit 110 may obtain the open circuit voltages of the plurality of battery cells after an elapse of a preset time from charging or discharging of the plurality of battery cells, in operation S110.

In operation S120, the controller 120 may calculate the first voltage of each of the plurality of battery cells, which is related to a change in open circuit voltage of the plurality of battery cells, for a preset time.

In operation S130, the controller 120 may calculate a second voltage that is an average of the first voltage of each of the plurality of battery cells.

In operation S140, the controller 120 may calculate a deviation based on the first voltage and the second voltage of each of the plurality of battery cells.

In operation S150, the controller 120 may diagnose the plurality of battery cells based on a ratio and a deviation of the first voltage and the second voltage of each of the plurality of battery cells. For example, in operation S150, the controller 120 may diagnose, among the plurality of battery cells, as a defective battery cell, a battery cell having a ratio of the first voltage and the second voltage being out of a preset range.

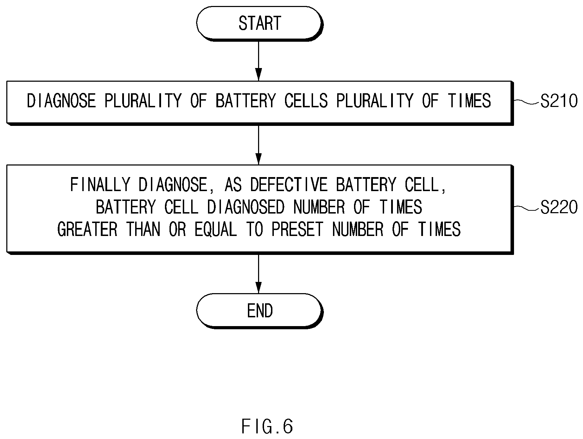

FIG. 6 is a flowchart showing an operating method of a battery management apparatus, according to an embodiment disclosed herein.

According to an embodiment, operations shown in FIG. 6 may be performed by the battery management apparatus 100 of FIG. 2.

Referring to FIG. 6, the controller 120 may diagnose the plurality of battery cells a plurality of times, in operation S210. For example, the controller 120 may diagnose the plurality of battery cells for every discharging after the plurality of battery cells are discharged a plurality of times.

In operation S220, the controller 120 may finally diagnose, as a defective battery cell, a battery cell having a number of times of diagnosis being greater than or equal to a preset number of times.

According to an embodiment, operations S210 to S240 may be performed through operation S150 of FIG. 5.

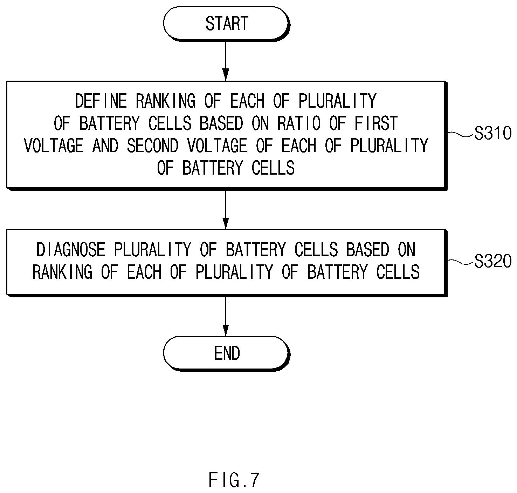

FIG. 7 is a flowchart showing an operation of a battery management apparatus, according to another embodiment disclosed herein. According to an embodiment, operations shown in FIG. 7 may be performed by the battery management apparatus 100 of FIG. 2.

Referring to FIG. 7, in operation S310, the controller 120 may define a ranking of each of the plurality of battery cells based on the ratio of the first voltage and the second voltage of each of the plurality of battery cells.

In operation S320, the controller 120 may diagnose the plurality of battery cells, based on the ranking of each of the plurality of battery cells. According to an embodiment, operation S320 may be performed simultaneously with operation S150. That is, the controller 120 may diagnose the plurality of battery cells, based on the ranking, the ratio, and the deviation of each of the plurality of battery cells.

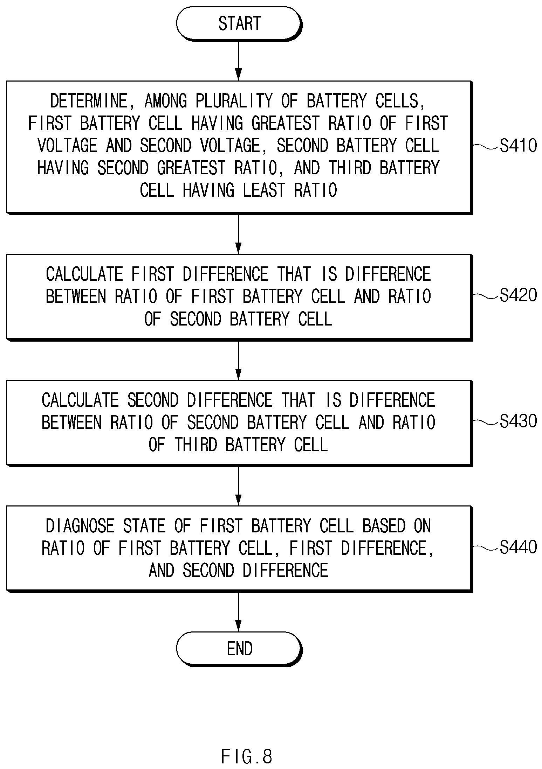

FIG. 8 is a flowchart showing in detail an operation of a battery management apparatus, according to another embodiment disclosed herein. According to an embodiment, operations shown in FIG. 8 may be performed by the battery management apparatus 100 of FIG. 2.

Referring to FIG. 8, in operation S410, the controller 120 may determine, among the plurality of battery cells, the first battery cell having the greatest ratio of the first voltage and the second voltage, the second battery cell having the second greatest ratio, and the third battery cell having the least ratio.

In operation S420, the controller 120 may calculate the first difference that is a difference between the ratio of the first battery cell and the ratio of the second battery cell.

In operation S430, the controller 120 may calculate the second difference that is a difference between the ratio of the second battery cell and the ratio of the third battery cell.

In operation S440, the controller 120 may diagnose the state of the first battery cell based on the ratio of the first battery cell, the first difference, and the second difference.

Operations S410 to S440 may be performed through operation S320 of FIG. 7.

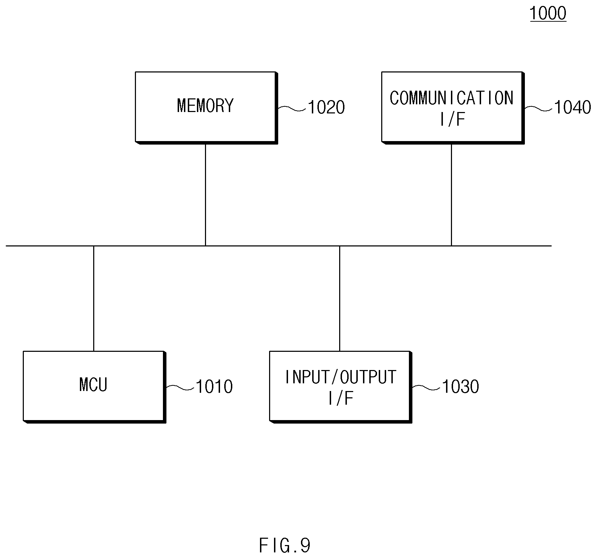

FIG. 9 is a block diagram showing a hardware configuration of a computing system for performing an operating method of a battery management apparatus, according to an embodiment disclosed herein.

Referring to FIG. 9, a computing system 1000 according to an embodiment disclosed herein may include a microcontroller unit (MCU) 1010, a memory 1020, an input/output interface (I/F) 1030, and a communication I/F 1040.

The MCU 1010 may be a processor that executes various programs (e.g., a program for collecting voltages and currents of the plurality of battery cells, a program for calculating a voltage change of the plurality of battery cells, a program for calculating an average in voltage change of the plurality of battery cells, a program for diagnosing the plurality of battery cells, etc.) stored in the memory 1020, processes various information including the voltages and currents, the voltage change, the average in voltage change, and tab disconnection of the plurality of battery cells, etc., through these programs, and executes the above-described functions of the controller included in the battery management apparatus shown in FIG. 2.

The memory 1020 may store various programs such as a program for collecting voltages and currents of the plurality of battery cells, a program for calculating a voltage change of the plurality of battery cells, a program for calculating an average in voltage change of the plurality of battery cells, a program for diagnosing the plurality of battery cells, etc. Moreover, the memory 1020 may store various information such as the voltages and currents, the voltage change, the average in voltage change, and tab disconnection of the plurality of battery cells.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery management apparatus may transmit and receive various information including the voltages and currents, the voltage change, the average in voltage change, and tab disconnection of the plurality of battery cells from an external server separately provided through the communication I/F 1040.

As such, a computer program according to an embodiment disclosed herein may be recorded in the memory 1020 and processed by the MCU 1010, thus being implemented as a module that performs functions shown in FIG. 2.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery management apparatus comprising:
an information obtaining unit configured to obtain an open circuit voltage of a plurality of battery cells; and
a controller configured to:
calculate a first voltage of each of the plurality of battery cells, which is related to a change in open circuit voltage of the plurality of battery cells, for a preset time;
calculate a second voltage that is an average of the first voltage of each of the plurality of battery cells;
calculate a deviation based on a first voltage and a second voltage of each of the plurality of battery cells; and
diagnose the plurality of battery cells based on a ratio of the first voltage and the second voltage of each of the plurality of battery cells and the deviation.

2. The battery management apparatus of claim 1, wherein the controller is further configured to:
diagnose the plurality of battery cells a plurality of times; and
finally diagnose, as a defective battery cell, a battery cell diagnosed a number of times greater than or equal to a preset number of times.

3. The battery management apparatus of claim 2, wherein the controller is further configured to diagnose the plurality of battery cells every discharging after the plurality of battery cells are discharged a plurality of times.

4. The battery management apparatus of claim 1, wherein the controller is further configured to diagnose, among the plurality of battery cells, as a defective battery cell, a battery cell having a ratio of a first voltage and a second voltage, the ratio being out of a preset range.

5. The battery management apparatus of claim 1, wherein the first voltage is an open circuit voltage recovered after a battery cell is used.

6. The battery management apparatus of claim 1, wherein the information obtaining unit is further configured to obtain an open circuit voltage of the plurality of battery cells after a preset time from charging or discharging of the plurality of battery cells.

7. The battery management apparatus of claim 1, wherein the controller is further configured to diagnose, among the plurality of battery cells, as a defective battery cell, a battery cell having a ratio and a deviation of a first voltage and a second voltage, the ratio being out of a preset range and the deviation being greater than or equal to a set value.

8. The battery management apparatus of claim 7, wherein the controller is further configured to finally diagnose a battery cell as a defective battery cell when the battery cell is diagnosed, as having the ratio being out of the preset range and the deviation of the second voltage being greater than or equal to the preset value, continuously a preset number of times.

9. The battery management apparatus of claim 1, wherein the controller is further configured to determine a battery cell as noise without performing diagnosis, when the battery cell has a change in open circuit voltage of the plurality of battery cells, the change being greater than or equal to a threshold value.

10. The battery management apparatus of claim 1, wherein the controller is further configured to:
define a ranking of each of the plurality of battery cells based on a ratio of the first voltage and the second voltage of each of the plurality of battery cells; and
diagnose the plurality of battery cells based on the ranking of each of the plurality of battery cells.

11. The battery management apparatus of claim 10, wherein the controller is further configured to:
determine, among the plurality of battery cells, a first battery cell having the greatest ratio of the first voltage and the second voltage, a second battery cell having the second greatest ratio, and a third battery cell having the least ratio;
calculate a first difference that is a difference between the ratio of the first battery cell and the ratio of the second battery cell;
calculate a second difference that is a difference between the ratio of the second battery cell and the ratio of the third battery cell; and
diagnose a state of the first battery cell based on the ratio of the first battery cell, the first difference, and the second difference.

12. The battery management apparatus of claim 11, wherein the controller is further configured to diagnose, as a defective battery cell, a battery cell having a ratio of the first battery cell being greater than or equal to a first threshold value, a ratio of the first difference and the second difference being greater than or equal to a second threshold value, and the deviation being greater than or equal to a preset value.

13. An operating method of a battery management apparatus, the operating method comprising:
obtaining an open circuit voltage of a plurality of battery cells;
calculating a first voltage of each of the plurality of battery cells, which is related to a change in open circuit voltage of the plurality of battery cells, for a preset time;
calculating a second voltage that is an average of the first voltage of each of the plurality of battery cells;
calculating a deviation based on a first voltage and a second voltage of each of the plurality of battery cells; and
diagnosing the plurality of battery cells based on a ratio of the first voltage and the second voltage of each of the plurality of battery cells and the deviation.

14. The operating method of claim 13, wherein the defining of the plurality of battery cells based on the ratio of the first voltage and the second voltage of each of the plurality of battery cells comprises:
diagnosing the plurality of battery cells a plurality of times; and
finally diagnosing, as a defective battery cell, a battery cell diagnosed a number of times greater than or equal to a preset number of times.

15. The operating method of claim 14, wherein the diagnosing of the plurality of battery cells a plurality of times comprises diagnosing the plurality of battery cells every discharging after the plurality of battery cells are discharged a plurality of times.

16. The operating method of claim 13, wherein the defining of the plurality of battery cells based on the ratio of the first voltage and the second voltage of each of the plurality of battery cells comprises diagnosing, among the plurality of battery cells, as a defective battery cell, a battery cell having a ratio of a first voltage and a second voltage, the ratio being out of a preset range.

17. The operating method of claim 13, wherein the obtaining of the open circuit voltage of a plurality of battery cells comprises obtaining an open circuit voltage of the plurality of battery cells after a preset time from charging or discharging of the plurality of battery cells.

18. The operating method of claim 13, further comprising:
defining a ranking of each of the plurality of battery cells based on a ratio of the first voltage and the second voltage of each of the plurality of battery cells; and
diagnosing the plurality of battery cells based on the ranking of each of the plurality of battery cells.

19. The operating method of claim 18, wherein the diagnosing of the plurality of battery cells based on the ranking of each of the plurality of battery cells comprises:
determining, among the plurality of battery cells, a first battery cell having the greatest ratio of the first voltage and the second voltage, a second battery cell having the second greatest ratio, and a third battery cell having the least ratio;
calculating a first difference that is a difference between the ratio of the first battery cell and the ratio of the second battery cell;
calculating a second difference that is a difference between the ratio of the second battery cell and the ratio of the third battery cell; and
diagnosing a state of the first battery cell based on the ratio of the first battery cell, the first difference, and the second difference.
